# EUROPÄISCHE PATENTSCHRIFT

(11) **EP 2 162 927 B1**
(45) Veröffentlichungstag und Bekanntmachung des Hinweises auf die Patenterteilung: **24.10.2018**
(21) Anmeldenummer: 08758035.3
(22) Anmeldetag: 07.05.2008
(51) Int. Cl.: H01L 33/00, H01L 25/075, H01L 21/78, H01L 21/68

(54) **VERFAHREN ZUR HERSTELLUNG VON OPTOELEKTRONISCHEN BAUELEMENTEN**
METHOD FOR PRODUCING OPTOELECTRONIC COMPONENTS
PROCÉDÉ DE FABRICATION DE COMPOSANTS OPTOÉLECTRONIQUES

(30) Priorität: 29.06.2007 DE 102007030314; 14.09.2007 DE 102007043877
(43) Veröffentlichungstag der Anmeldung: 17.03.2010
(73) Patentinhaber: OSRAM Opto Semiconductors GmbH, 93055 Regensburg (DE)
(72) Erfinder: FISCHER, Helmut, 93138 Lappersdorf (DE); EISSLER, Dieter, 93152Nittendorf/Etterzhausen (DE); HEINDL, Alexander, 93326 Abensberg (DE)
(74) Vertreter: Epping - Hermann - Fischer
(86) Internationale Anmeldenummer: PCT/DE2008/000776
(87) Internationale Veröffentlichungsnummer: WO 2009/003435

(56) Entgegenhaltungen:
- EP-A- 0 905 797
- EP-A2- 1 526 574
- WO-A-2007/052241
- JP-A- 11 191 642
- JP-A- 56 017 384
- US-A1- 2002 064 032
- US-A1- 2005 148 106
- US-A1- 2007 077 673
- US-B2- 7 125 734

## Beschreibung

Die vorliegende Anmeldung betrifft ein Verfahren zur Herstellung einer Mehrzahl von optoelektronischen Bauelementen

Optoelektronische Bauelemente werden meist in einer Vielzahl von Einzelschritten hergestellt. Hierbei werden beispielsweise werden zur Strahlungserzeugung vorgesehene Halbleiterchips oftmals in Gehäusekörper eingesetzt. Dies kann mittels des so genannten Pick-and-Place-Verfahrens durchgeführt werden, bei dem die Halbleiterchips einzeln in den Gehäusekörpern platziert werden. Eine derartige Herstellung von optoelektronischen Bauelementen ist vergleichsweise aufwändig und kostenintensiv.

US 7 125 734 B2 beschreibt ein Verfahren zur Herstellung einer Mehrzahl von optoelektronischen Bauelementen, bei dem die Aufwachssubstratkörper von den jeweiligen Halbleiterkörpern entfernt werden nachdem die Halbleiterkörper an einem Bauelementträger befestigt werden.

US 2002/064032 A1 offenbart die Anordnung einzelner getrennter Dünnfilm-LED-Chips ohne Aufwachssubstrat auf einem Montageträger, wobei ein selektiver Übertrag der Dünnfilm-LED-Chips mittels eines temporären dehnbaren Hilfsträgers erfolgt.

JP 56 017384 A beschreibt ein Verfahren zur Herstellung eines Displaybauelements, bei dem ein selektiver Übertrag von LED-Chips von einem Hilfsträger auf ein Montagesubstrat durch Erwärmen erfolgt.

US 2005/148106 A1 beschreibt den Transfer von LED-Chips ohne Aufwachssubstrat auf eine Hilfsträgerfolie, wobei die Hafteigenschaften der Folie mittels elektromagnetischer Strahlung selektiv verändert werden. 1

EP 1 526 574 A2 beschreibt einen selektiven Übertrag von LED-Chips mit einer Folie, deren Hafteigenschaften mittels elektromagnetischer Strahlung verändert werden, wobei das Aufwachssubstrat bereits beim Aufbringen der LED-Chips auf die Folie entfernt wird und das Aufwachssubstrat wiederholt verwendet wird.

Es ist eine Aufgabe ein Verfahren anzugeben, mit dem eine Mehrzahl von optoelektronischen Bauelementen vereinfacht, vorzugsweise in einem Massenfertigungsverfahren, hergestellt werden kann. Weiterhin soll ein optoelektronisches Bauelement angegeben werden, das vereinfacht herstellbar ist.

Diese Aufgabe wird durch den unabhängigen Patentanspruch gelöst, der die vorliegende Erfindung definiert. Vorteilhafte Ausgestaltungen und Weiterbildungen sind Gegenstand der abhängigen Patentansprüche.

In der folgenden Beschreibung bezeichnen die Begriffe "Ausgestaltungsvariante", "Ausgestaltung", "Ausführungsbeispiel" und "Ausführungsform" nur dann Ausführungsbeispiele der vorliegenden Erfindung, wenn sie jeweils alle im Anspruch 1 definierten Merkmale enthalten. Ansonsten bezeichnen diese Begriffe lediglich andere Beispiele, die für das Verstehen der vorliegenden in Anspruch 1 definierten Erfindung hilfreich sind.

Gemäß einer Ausführungsform wird bei einem Verfahren zur Herstellung einer Mehrzahl von optoelektronischen Bauelementen eine Mehrzahl von Halbleiterkörpern mit jeweils einer Halbleiterschichtenfolge bereitgestellt. Weiterhin wird
ein Bauelementträgerverbund mit einer Mehrzahl von Anschlussflächen bereitgestellt. Die Halbleiterkörper werden relativ zum Bauelementträgerverbund positioniert. Zwischen den Anschlussflächen und den zugeordneten Halbleiterkörpern wird jeweils eine elektrisch leitende Verbindung hergestellt und diese Halbleiterkörper werden an dem Bauelementträgerverbund befestigt. Die Mehrzahl von optoelektronischen Bauelementen wird fertig gestellt, wobei für jedes optoelektronische Bauelement ein Bauelementträger aus dem Bauelementträgerverbund ausgebildet wird.

Die Bauelementträger werden also aus dem Bauelementträgerverbund ausgebildet, nachdem auf einem für den Bauelementträger vorgesehenen Bereich des Bauelementträgerverbunds bereits der zugehörige zumindest eine Halbleiterkörper befestigt und elektrisch leitend mit der entsprechenden Anschlussfläche verbunden ist. Auf ein aufwändiges Pick-and-Place-Verfahren zur Montage der Halbleiterkörper in separaten Bauelementträgern kann verzichtet werden. Die Herstellung der optoelektronischen Bauelemente wird so vereinfacht.

In einer Ausgestaltungsvariante werden die Halbleiterkörper auf einem Hilfsträger bereitgestellt. Die Halbleiterkörper sind also auf einem Hilfsträger angeordnet. Dieser Hilfsträger kann derart relativ zum Bauelementträgerverbund positioniert werden, dass die Halbleiterkörper dem Bauelementträgerverbund zugewandt sind. Auf diese Weise kann eine Vielzahl von Halbleiterkörpern, insbesondere gleichzeitig, relativ zum Bauelementträgerverbund positioniert werden. Die Herstellung wird dadurch vereinfacht.

In einer alternativen Ausgestaltungsvariante, die nicht Bestandteil der vorliegenden Erfindung ist, werden die Halbleiterkörper einzeln, etwa in einem Pick-and-Place-Verfahren, auf dem Bauelementträgerverbund angeordnet. Die einzelnen Halbleiterkörper können so unabhängig voneinander positioniert werden.

In einer bevorzugten Ausgestaltung sind die Halbleiterkörper jeweils auf einem Aufwachssubstratkörper für die Halbleiterschichtenfolge des Halbeiterkörpers ausgebildet. Die Aufwachssubstratkörper können, insbesondere nach dem Herstellen der elektrisch leitenden Verbindung der Anschlussflächen mit den Halbleiterkörpern, vollständig entfernt oder teilweise entfernt, etwa vollflächig oder bereichsweise gedünnt oder bereichsweise entfernt, werden. Die Aufwachssubstratkörper können also während der Herstellung der optoelektronischen Bauelemente insbesondere der mechanischen Stabilisierung der Halbleiterkörper dienen. Auf eine zusätzliche mechanische Stabilisierung der Halbleiterkörper kann also verzichtet werden. Im fertig gestellten optoelektronischen Bauelement sind die Aufwachssubstratkörper dagegen hierfür nicht mehr erforderlich. Vielmehr können die Aufwachssubstratkörper während der Herstellung vollständig entfernt werden. So können die Aufwachssubstratkörper unabhängig von ihren optischen Eigenschaften gewählt werden.

Gemäß einer weiteren Ausführungsform werden bei einem Verfahren zur Herstellung einer Mehrzahl von optoelektronischen Bauelementen eine Mehrzahl von Halbleiterkörpern mit jeweils einer Halbleiterschichtenfolge bereitgestellt, wobei die Halbleiterkörper jeweils auf einem Aufwachssubstratkörper für die Halbleiterschichtenfolge ausgebildet sind. Weiterhin wird eine Mehrzahl von Bauelementträgern, die jeweils zumindest eine Anschlussfläche aufweisen, bereitgestellt. Die Halbleiterkörper werden relativ zu den Bauelementträgern positioniert. Eine elektrisch leitende Verbindung der Anschlussflächen der Bauelementträger mit den den Anschlussflächen zugeordneten Halbleiterkörpern wird hergestellt und diese Halbleiterkörper werden an den Bauelementträgern befestigt. Die Mehrzahl von optoelektronischen Bauelementen wird fertig gestellt, wobei die Aufwachssubstratkörper von den jeweiligen Halbleiterkörpern nach dem Herstellen der elektrisch leitenden Verbindung und dem Befestigen der Halbleiterkörper an dem Bauelementträger vollständig oder teilweise, etwa vollflächig oder bereichsweise gedünnt oder bereichsweise entfernt, entfernt werden.

Das Entfernen der Aufwachssubstratkörper erfolgt also, nachdem die Halbleiterkörper bereits an dem zugeordneten Bauelementträger befestigt sind. Vor dem Befestigen der Halbleiterkörper an dem Bauelementträger können also die Aufwachssubstratkörper der mechanischen Stabilisierung der zugeordneten Halbleiterkörper dienen. Im fertig gestellten optoelektronischen Bauelement sind die Aufwachssubstratkörper nicht mehr oder nur noch teilweise vorhanden. Bei vollständig entfernten Aufwachssubstratkörpern sind die optoelektronischen Eigenschaften der optoelektronischen Bauelemente unabhängig von dem Aufwachssubstratkörper. Die Aufwachssubstratkörper für die Halbleiterschichtenfolge der Halbleiterkörper können somit unabhängig von ihren optischen Eigenschaften gewählt werden. Insbesondere können die Aufwachssubstratkörper für die im Halbleiterkörper erzeugte Strahlung undurchlässig ausgebildet sein.

In einer Ausgestaltungsvariante der weiteren Ausführungsform werden die Halbleiterkörper auf einem Hilfsträger bereitgestellt. Die Halbleiterkörper sind also auf einem Hilfsträger angeordnet. Dieser Hilfsträger kann derart relativ zu den Bauelementträgern positioniert werden, dass die Halbleiterkörper den Bauelementträgern zugewandt sind. Auf diese Weise kann eine Vielzahl von Halbleiterkörpern, insbesondere gleichzeitig, relativ zu den Bauelementträgern positioniert werden. Die Herstellung wird dadurch vereinfacht.

In einer alternativen Ausgestaltungsvariante der weiteren Ausführungsform, die nicht Bestandteil der vorliegenden Erfindung ist, werden die Halbleiterkörper einzeln, etwa in einem Pick-and-Place-Verfahren, auf den Bauelementträgern angeordnet. Die einzelnen Halbleiterkörper können so unabhängig voneinander positioniert werden.

In einer bevorzugten Ausgestaltung der weiteren Ausführungsform des Verfahrens werden die Bauelementträger in einem Bauelementträgerverbund bereitgestellt. Aus dem Bauelementträgerverbund können die Bauelementträger ausgebildet werden. Besonders bevorzugt werden die Bauelementträger nach dem vollständigen oder teilweisen Entfernen der Aufwachssubstratkörper aus dem Bauelementträgerverbund ausgebildet.

Die optoelektronischen Bauelemente können durch Vereinzeln des Bauelementträgerverbunds in die Bauelementträger fertig gestellt werden. Auf aufwändige Herstellungsschritte, die nach dem Vereinzeln des Bauelementträgerverbunds auf einzelnen Bauelementträgern durchzuführen sind, kann so verzichtet werden. Die Herstellung der optoelektronischen Bauelemente wird so vereinfacht.

Beim Befestigen der Halbleiterkörper auf den Bauelementträgern verlaufen der Hilfsträger und der Bauelementträgerverbund vorzugsweise parallel oder im Wesentlichen parallel zueinander. Die Halbleiterkörper können so flächig auf dem Bauelementträgerverbund bereitgestellt werden.

Weiterhin bevorzugt werden die Bauelementträger aus dem Bauelementträgerverbund ausgebildet, nachdem die Aufwachssubstratkörper von den jeweiligen Halbleiterkörpern bereits entfernt sind. Das Entfernen der Aufwachssubstratkörper kann so noch im Verbund durchgeführt werden.

Die Halbleiterkörper weisen vorzugsweise jeweils zumindest einen aktiven Bereich auf, der zur Erzeugung von Strahlung vorgesehen ist. Die erzeugte Strahlung kann inkohärent, teilkohärent oder kohärent sein. Insbesondere können die Halbleiterkörper als Lumineszenzdioden-Halbleiterkörper, etwa als LED-Halbleiterkörper, RCLED (resonant cavity light emitting diode) oder als Laserdiodenhalbleiterkörper ausgeführt sein.

In einer bevorzugten Ausgestaltung ist auf zumindest einem Halbleiterkörper eine Kontaktfläche ausgebildet, die mit der zugehörigen Anschlussfläche auf dem Bauelementträger elektrisch leitend verbunden ist. Weiterhin bevorzugt ist auf dem Halbleiterkörper eine weitere Kontaktfläche ausgebildet, die mit einer weiteren Anschlussfläche auf dem Bauelementträger verbunden ist. Der Halbleiterkörper kann also zwei Kontaktflächen aufweisen, die jeweils mit einer Anschlussfläche verbunden sind. Im Betrieb des optoelektronischen Bauelements kann durch Anlegen einer externen elektrischen Spannung zwischen den Anschlussflächen über die Kontaktflächen ein elektrischer Strom in den zur Erzeugung von Strahlung vorgesehenen aktiven Bereich des Halbleiterkörpers injiziert werden.

In einer bevorzugten Weiterbildung sind die Kontaktfläche und die weitere Kontaktfläche auf derselben Seite des aktiven Bereichs ausgebildet. Der Halbleiterkörper ist somit von einer Seite elektrisch kontaktierbar. Insbesondere können die Kontaktfläche und die weitere Kontaktfläche auf einer dem Halbleiterkörper abgewandten Seite eine gemeinsame Ebene bilden. Mit anderen Worten können die dem Halbleiterkörper abgewandten Begrenzungsflächen der Kontaktflächen innerhalb einer Ebene verlaufen. Die elektrische Kontaktierung des Halbleiterkörpers wird dadurch weitergehend vereinfacht.

Die Kontaktflächen enthalten vorzugsweise ein Metall oder eine metallische Legierung.

In einer bevorzugten Ausgestaltung ist der Bauelementträger jeweils aus der Gruppe bestehend aus Leiterplatte, mit Metallkernleiterplatte, Keramikkörper mit Anschlussflächen und Leiterrahmen gewählt. Insbesondere kann der Bauelementträger starr oder flexibel ausgebildet sein.

Bei der Herstellung der optoelektronischen Bauelemente können die Bauelementträger beispielsweise mittels mechanischen Zerteilens aus dem Bauelementträgerverbund hervorgehen. Insbesondere können die Bauelementträger mittels Sägens, Schneidens, Stanzens oder Brechens, aus dem Bauelementträgerverbund ausgebildet werden.

Alternativ kann für das Ausbilden der Bauelementträger aus dem Bauelementträgerverbund auch elektromagnetische Strahlung, insbesondere kohärente Strahlung, etwa Laserstrahlung, Anwendung finden.

In einer weiteren bevorzugten Ausgestaltung ist der Hilfsträger mit separaten Halbleiterkörpern versehen, die besonders bevorzugt bezüglich ihrer Funktionsfähigkeit und weitergehend bezüglich ihrer optoelektronischen Eigenschaften, etwa Helligkeit, Abstrahlcharakteristik oder Farbort, vorselektiert sind. Insbesondere können die optoelektronischen Eigenschaften bereits vor der Montage der Halbleiterkörper auf den jeweiligen Bauelementträgern bezüglich dieser Eigenschaften vermessen werden. Auf diese Weise kann gewährleistet werden, dass die Bauelementträger jeweils nur mit Halbleiterkörpern bestückt werden, die den vorgegebenen optoelektronischen Eigenschaften entsprechen. Das Messen dieser Eigenschaften kann bereits vor dem Platzieren der Halbleiterkörper auf dem Hilfsträger erfolgen. Alternativ oder ergänzend können Messungen auf dem Hilfsträger durchgeführt werden. Halbleiterkörper, die nicht die vorgegebenen optoelektronischen Eigenschaften erfüllen, können dann vom Hilfsträger entfernt und weiterhin bevorzugt durch einen anderen Halbleiterkörper ersetzt werden.

Gemäß der vorliegenden Erfindung werden die Halbleiterkörper selektiv von dem Hilfsträger gelöst, nachdem die Halbleiterkörper an dem Bauelementträger befestigt sind. Insbesondere können die Halbleiterkörper mittels selektiver Belichtung des Hilfsträgers, etwa mittels kohärenter Strahlung, etwa Laserstrahlung, von dem Hilfsträger gelöst werden.

Den Halbleiterkörpern, die zur Befestigung an dem Bauelementträger beziehungsweise an dem Bauelementträgerverbund vorgesehen sind, ist vorzugsweise jeweils ein Montagebereich auf dem Bauelementträger beziehungsweise dem Bauelementträgerverbund zugeordnet.

Besonders bevorzugt werden diejenigen Halbleiterkörper vom Hilfsträger getrennt, die beim Positionieren des Hilfsträgers innerhalb des Montagebereichs auf dem Bauelementträger beziehungsweise dem Bauelementträgerverbund angeordnet werden. Halbleiterkörper, die relativ zum Bauelementträger beziehungsweise zum Bauelementträgerverbund außerhalb eines Montagebereichs angeordnet sind, können auf dem Hilfsträger verbleiben und beispielsweise in einem nachfolgenden Herstellungsschritt auf einem weiteren Bauelementträger beziehungsweise Bauelementträgerverbund befestigt werden. Insbesondere können alle auf dem Hilfsträger angeordneten Halbleiterkörper auf einem Bauelementträger beziehungsweise Bauelementträgerverbund montiert werden.

Weiterhin kann auf dem Hilfsträger zwischen zwei Halbleiterkörpern, die bei der Montage der Halbleiterkörper auf den Bauelementträgern beziehungsweise auf dem Bauelementträgerverbund nebeneinander befestigt werden, zumindest ein weiterer Halbleiterkörper angeordnet sein. Die Anzahl der Halbleiterkörper, die auf dem Hilfsträger auf einer Fläche angeordnet sind, kann also die Anzahl der Montagebereiche auf den Bauelementträgern beziehungsweise auf dem Bauelementträgerverbund auf einer gleich großen Fläche übersteigen. Die Packungsdichte der Halbleiterkörper auf dem Hilfsträger kann also höher sein als die Packungsdichte der Montagebereiche auf dem Bauelementträgerverbund beziehungsweise auf den Bauelementträgern.

Die Halbleiterkörper können beispielsweise in einem schachbrettartigen Muster abwechselnd entweder auf dem Hilfsträger verbleiben oder auf einem Bauelementträger beziehungsweise dem Bauelementträgerverbund montiert werden. Der Hilfsträger kann starr oder mechanisch flexibel ausgeführt sein. Ein flexibler Hilfsträger kann erforderlichenfalls auf der den Halbleiterkörpern abgewandten Seite auf einem weiteren Träger angeordnet sein, der den Hilfsträger mechanisch stabilisiert.

Gemäß der vorliegenden Erfindung ist der Hilfsträger als eine Folie ausgeführt. Insbesondere eignet sich eine Folie, deren Hafteigenschaften an den Halbleiterkörpern gezielt beeinflusst, insbesondere verringert, werden können. Dies kann beispielsweise mittels elektromagnetischer Strahlung, insbesondere kohärenter Strahlung, etwa Laserstrahlung, erfolgen. Auf diese Weise können die Halbleiterkörper vereinfacht selektiv von dem Hilfsträger entfernt werden.

Nach dem Befestigen der Halbleiterkörper an dem Bauelementträger kann der Hilfsträger, insbesondere der als Folie ausgeführte Hilfsträger, vollständig von dem Halbleiterkörper entfernt werden.

Alternativ kann auch ein Teil des Hilfsträgers, insbesondere des als Folie ausgeführten Hilfsträgers, im fertig gestellten optoelektronischen Bauelement an dem Halbleiterkörper verbleiben. Lediglich fertigungsbedingt an dem Halbleiterkörper verbleibende Spuren, etwa Reste eines Verbindungsmittels, werden hierbei nicht als Teil des Hilfsträgers verstanden. Beispielsweise kann mittels der Folie eine Umhüllung des Halbleiterkörpers oder ein Gehäusekörper für den Halbleiterkörper gebildet werden.

Die Aufwachssubstratkörper werden in einer bevorzugten Ausgestaltung mittels kohärenter Strahlung, etwa Laserstrahlung, von den jeweiligen Halbleiterkörpern entfernt. Alternativ können die Aufwachssubstratkörper mittels eines chemischen Prozesses, etwa nasschemischen oder trockenchemischen Ätzens, und/oder mittels eines mechanischen Prozesses, etwa Schleifens, Läppens oder Polierens, von den jeweiligen Halbleiterkörpern entfernt werden.

In einer bevorzugten Weiterbildung wird eine optoelektronische Eigenschaft von zumindest einem optoelektronischen Bauelement nach dem Befestigen des jeweiligen Halbleiterkörpers an dem Bauelementträger eingestellt.

Weiterhin bevorzugt kann ein Strahlungskonversionsstoff auf den jeweiligen Halbleiterkörpern ausgebildet werden. Mittels dieses Strahlungskonversionsstoffes kann die spektrale Abstrahlcharakteristik des optoelektronischen Bauelements eingestellt werden. Durch den Strahlungskonversionsstoff kann ein Teil der im aktiven Bereich des Halbleiterkörpers erzeugten Strahlung in Strahlung einer anderen Wellenlänge konvertiert werden. So kann mischfarbiges Licht, insbesondere für das menschliche Auge weiß erscheinendes Licht, erzeugt werden.

Besonders bevorzugt ist der Strahlungskonversionsstoff bezüglich seiner Menge und/oder seiner Zusammensetzung selektiv an den jeweiligen Halbleiterkörper angepasst. Hierfür können die Halbleiterkörper bereits vor oder nach dem Befestigen auf dem Hilfsträger, insbesondere bezüglich Funktionsfähigkeit und optoelektronischer Eigenschaften, charakterisiert werden. Alternativ oder ergänzend kann eine Messung der optoelektronischen Eigenschaften, etwa der Helligkeit und/oder des Farborts, nach der Befestigung des Halbleiterkörpers an dem Bauelementträger beziehungsweise an dem Bauelementträgerverbund durchgeführt werden.

Insbesondere kann durch eine an den jeweiligen Halbleiterkörper angepasste Dosierung des Strahlungskonversionsstoffs der Farbort des optoelektronischen Bauteils an eine vorgegebene Abstrahlcharakteristik angepasst werden.

In einer bevorzugten Ausgestaltung wird zumindest ein Halbleiterkörper mit einem optischen Element versehen. Dies erfolgt vorzugsweise noch bevor die Bauelementträger aus dem Bauelementträgerverbund ausgebildet werden.

Das optische Element kann vorgefertigt sein und beispielsweise mittels einer mechanischen Verbindung oder einer Klebeverbindung an dem Bauelementträger beziehungsweise dem Bauelementträgerverbund befestigt werden.

Alternativ kann das optische Element auf dem Halbleiterkörper ausgebildet werden. In diesem Fall kann das optische Element mittels einer Formmasse gebildet werden, die den Halbleiterkörper zumindest bereichsweise umformt und je nach vorgegebener Abstrahlcharakteristik geeignet ausgestaltet wird. Die Formmasse kann beispielsweise einen Kunststoff oder ein Silikon enthalten.

Das optische Element kann beispielsweise als eine Linse oder als ein Lichtleiter ausgeführt sein.

In einer weiteren bevorzugten Ausgestaltung wird der Halbleiterkörper mit einer Struktur versehen. Die Struktur kann insbesondere zur Steigerung der Auskoppeleffizienz des Halbleiterkörpers vorgesehen sein. Die Struktur wird vorzugsweise auf einer dem Bauelementträger abgewandten Seite des Halbleiterkörpers ausgebildet. Beispielsweise kann der Halbleiterkörper oder eine an den Halbleiterkörper angrenzende Schicht mit einer Aufrauung versehen werden. Alternativ oder ergänzend kann auf dem Halbleiterkörper ein photonischer Kristall angeordnet und/oder ausgebildet werden.

Die Struktur kann beispielsweise mechanisch, etwa mittels Schleifens, Läppens oder Polierens, oder chemisch, etwa mittels nasschemischen oder trockenchemischen Ätzens, hergestellt werden.

In einer weiteren bevorzugten Ausgestaltung wird zwischen die Bauelementträger beziehungsweise den Bauelementträgerverbund und die zugehörigen Halbleiterkörper ein Füllmaterial eingebracht. Ein Zwischenraum, der sich bei der Befestigung des Halbleiterkörpers an dem Bauelementträger beziehungsweise dem Bauelementträgerverbund zwischen dem Halbleiterkörper und dem Bauelementträger beziehungsweise dem Bauelementträgerverbund ausbilden kann, kann so zumindest bereichsweise gefüllt werden. Der Zwischenraum kann sich insbesondere in lateraler Richtung, also entlang einer Haupterstreckungsrichtung des Bauelementträgers beziehungsweise des Bauelementträgerverbunds, zwischen den Anschlussflächen und/oder zwischen den Kontaktflächen ausbilden. Das Füllmaterial kann die Halbleiterkörper, insbesondere beim Ablösen des jeweiligen Aufwachssubstratkörpers, mechanisch stabilisieren.

Das Füllmaterial ist vorzugsweise derart ausgeführt, dass Kapillareffekte ein Einbringen des Füllmaterials in Zwischenräume begünstigen. Hierfür weist das Füllmaterial vorzugsweise eine niedrige Viskosität auf.

Weiterhin ist das Füllmaterial zweckmäßigerweise elektrisch isolierend ausgeführt. Auf diese Weise können elektrische Kurzschlüsse zwischen zwei benachbarten Anschlussflächen vermieden werden.

Das Füllmaterial enthält vorzugsweise ein organisches Material, etwa ein Harz, insbesondere ein Reaktionsharz. Beispielsweise kann das Füllmaterial ein Epoxidharz enthalten. Weiterhin kann das Füllmaterial als ein Klebstoff ausgeführt sein.

Besonders bevorzugt wird das Füllmaterial vor dem Ablösen des jeweiligen Aufwachssubstratkörpers eingebracht. Auf diese Weise kann das Füllmaterial den Halbleiterkörper insbesondere beim Ablösen des Aufwachssubstratkörpers mechanisch stabilisieren.

Weiterhin bevorzugt wird das Füllmaterial in fließfähigen Zustand in den Zwischenraum eingebracht und nachfolgend gehärtet. Das Härten kann insbesondere thermisch induziert oder von elektromagnetischer Strahlung, insbesondere ultravioletter Strahlung, induziert erfolgen.

In einer bevorzugten Ausgestaltung werden die optoelektronischen Bauelemente in einer Vorrichtung hergestellt, in der die beschriebenen Herstellungsschritte durchgeführt werden. Die Herstellungsschritte können hierbei vollständig oder teilweise automatisiert, insbesondere nacheinander, durchgeführt werden. Die Herstellung der optoelektronischen Bauelemente wird dadurch vereinfacht.

Gemäß einer Ausführungsform weist ein optoelektronisches Bauelement einen Bauelementträger mit zumindest zwei Anschlussflächen und einen Halbleiterkörper mit einer Halbleiterschichtenfolge auf. Die Halbleiterschichtenfolge des Halbleiterkörpers umfasst vorzugsweise einen zur Erzeugung von Strahlung vorgesehenen aktiven Bereich. Auf dem Halbleiterkörper sind zumindest zwei Kontaktflächen ausgebildet, die jeweils mit einer Anschlussfläche elektrisch leitend verbunden sind. Ein Zwischenraum zwischen dem Halbleiterkörper und dem Bauelementträger ist zumindest teilweise mit einem Füllmaterial gefüllt.

Das Füllmaterial dient insbesondere der mechanischen Stabilisierung des Halbleiterkörpers. Der Halbleiterkörper kann also mittels des Füllmaterials sowohl während der Herstellung des optoelektronischen Bauelements als auch im Betrieb des optoelektronischen Bauelements mechanisch stabilisiert sein. Insbesondere wird hierdurch die Herstellung des optoelektronischen Bauelements, etwa das Ablösen eines Aufwachssubstratkörpers für den Halbleiterkörper, vereinfacht.

In einer bevorzugten Ausgestaltung ist der Zwischenraum in lateraler Richtung, also entlang einer Haupterstreckungsrichtung des Bauelementträgers, von den Anschlussflächen und/oder von den Kontaktflächen begrenzt. Insbesondere kann sich der Zwischenraum in lateraler Richtung zwischen den Anschlussflächen und/oder zwischen den Kontaktflächen erstrecken. Der Zwischenraum kann vollständig oder teilweise mit dem Füllmaterial gefüllt sein.

Die Kontaktflächen sind vorzugsweise auf derselben Seite des aktiven Bereichs ausgebildet. Die Herstellung einer elektrisch leitenden Verbindung zu den Anschlussflächen des Bauelementträgers wird so vereinfacht.

Der Halbleiterkörper, insbesondere der aktive Bereich, enthält in einer bevorzugten Ausgestaltung ein III-V-Halbleitermaterial. Mit III-V-Halbleitermaterialien können bei der Strahlungserzeugung hohe interne Quanteneffizienzen erzielt werden.

Das weiter oben beschriebene Verfahren ist zur Herstellung des optoelektronischen Bauelements besonders geeignet. Im Zusammenhang mit dem beschriebenen Verfahren aufgeführte Merkmale können daher auch für das optoelektronische Bauelement herangezogen werden und umgekehrt.

Weitere Merkmale, vorteilhafte Ausgestaltungen und Zweckmäßigkeiten ergeben sich aus der folgenden Beschreibung der Ausführungsbeispiele in Verbindung mit den Figuren.

Es zeigen:
Die Figuren 1A bis 1H ein erstes Ausführungsbeispiel für ein Verfahren zur Herstellung von optoelektronischen Bauelementen anhand von Zwischenschritten in schematischer Schnittansicht,
Die Figuren 2A bis 2G ein zweites Ausführungsbeispiel für ein Verfahren zur Herstellung von optoelektronischen Bauelementen anhand von Zwischenschritten in schematischer Schnittansicht,
Die Figuren 3A bis 3G ein drittes Ausführungsbeispiel für ein Verfahren zur Herstellung von optoelektronischen Bauelementen anhand von Zwischenschritten in schematischer Schnittansicht,
Figur 4 ein Ausführungsbeispiel für einen Halbleiterkörper in schematischer Schnittansicht, und
Figur 5 ein Ausführungsbeispiel für ein optoelektronisches Bauelement in schematischer Schnittansicht.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

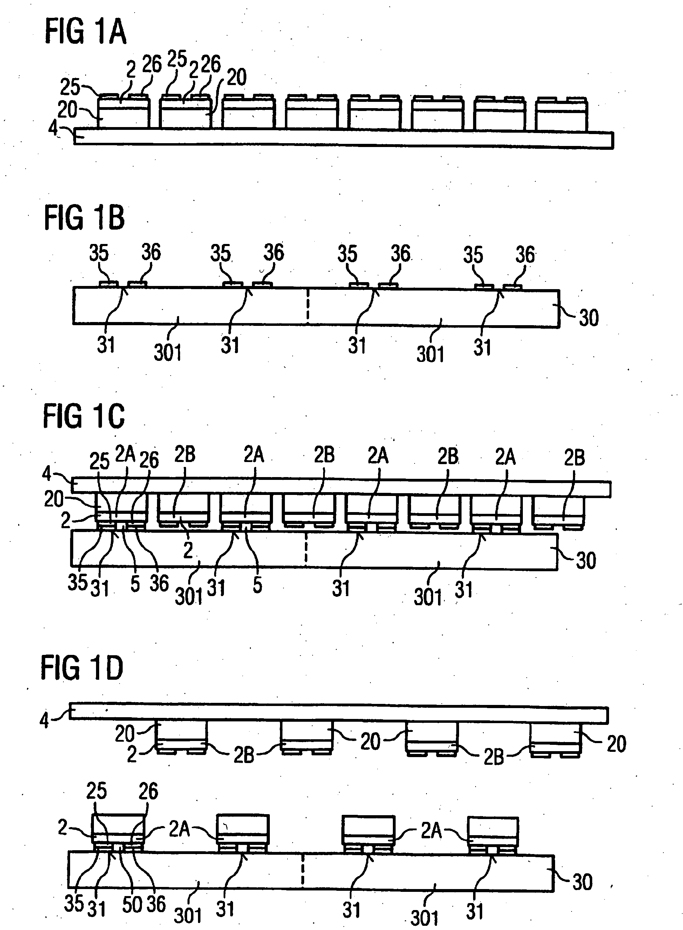

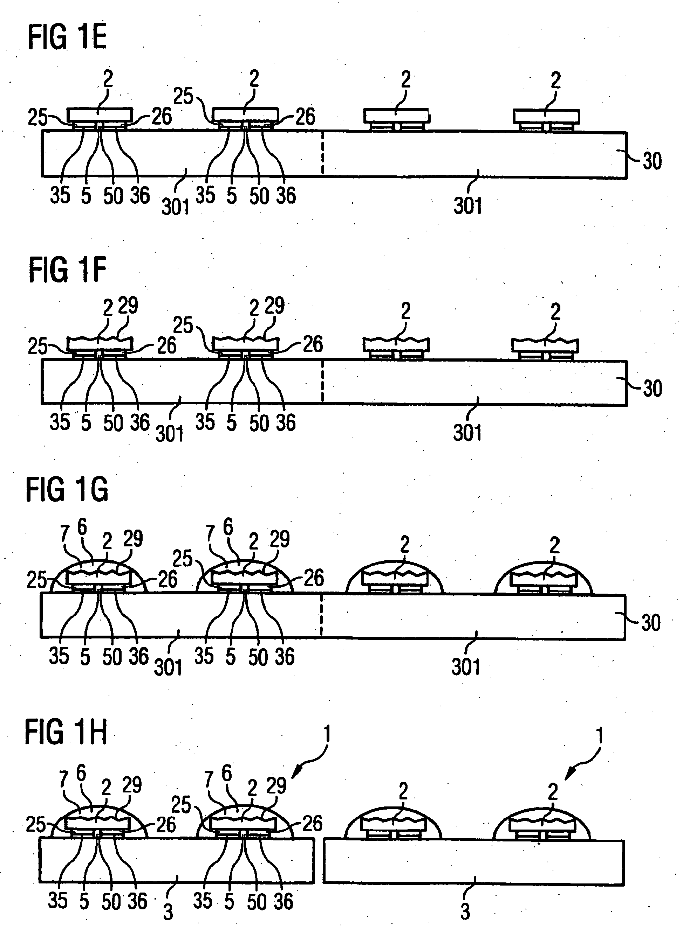

In den Figuren 1A bis 1H ist ein erstes Ausführungsbeispiel für ein Verfahren zur Herstellung von optoelektronischen Bauelementen schematisch anhand von Zwischenschritten in Schnittansicht dargestellt.

Wie in Figur 1A dargestellt, wird auf einem Hilfsträger 4 eine Mehrzahl von Halbleiterkörpern 2 mit jeweils einer Halbleiterschichtenfolge bereitgestellt. Die Halbleiterschichtenfolge bildet den Halbleiterkörper 2. Die Halbleiterkörper 2 sind jeweils auf einem Aufwachssubstratkörper 20 angeordnet. Die Herstellung der Halbleiterschichtenfolge der Halbleiterkörper erfolgt vorzugsweise in einem Epitaxieverfahren, etwa MOVPE oder MBE. Die Halbleiterkörper sind jeweils auf der dem Hilfsträger 4 abgewandten Seite der Aufwachssubstratkörper 20 angeordnet.

Auf den den jeweiligen Aufwachssubstratkörpern 20 abgewandten Seiten der Halbleiterkörper 2 sind jeweils eine Kontaktfläche 25 und eine weitere Kontaktfläche 26 ausgebildet. Die Kontaktfläche 25 und die weitere Kontaktfläche 26 sind also auf derselben Seite des Halbleiterkörpers angeordnet.

Die Kontaktflächen 25, 26 sind zweckmäßigerweise elektrisch leitend ausgeführt. Bevorzugt enthalten die Kontaktfläche ein Metall, etwa Au, Sn, Ni, Ti, Al oder Pt, oder eine metallische Legierung mit zumindest einem der genannten Metalle, etwa AuGe oder AuSn. Die Kontaktflächen können auch mehrschichtig ausgeführt sein.

Die Halbleiterkörper 2 mit den Aufwachssubstratkörpern 20 und den Kontaktflächen 25, 26 sind in Figur 1A zur verbesserten Übersichtlichkeit stark vereinfacht dargestellt. Beispielsweise können die Halbleiterkörper jeweils einen zur Erzeugung von Strahlung vorgesehenen aktiven Bereich aufweisen. Dies ist in Figur 1A nicht explizit gezeigt. Der Halbleiterkörper kann beispielsweise als LED-Halbleiterkörper, als RCLED-Halbleiterkörper oder als Laserdioden-Halbleiterkörper vorgesehen sein. Entsprechend kann die im Betrieb emittierte Strahlung inkohärent, teilkohärent beziehungsweise kohärent sein.

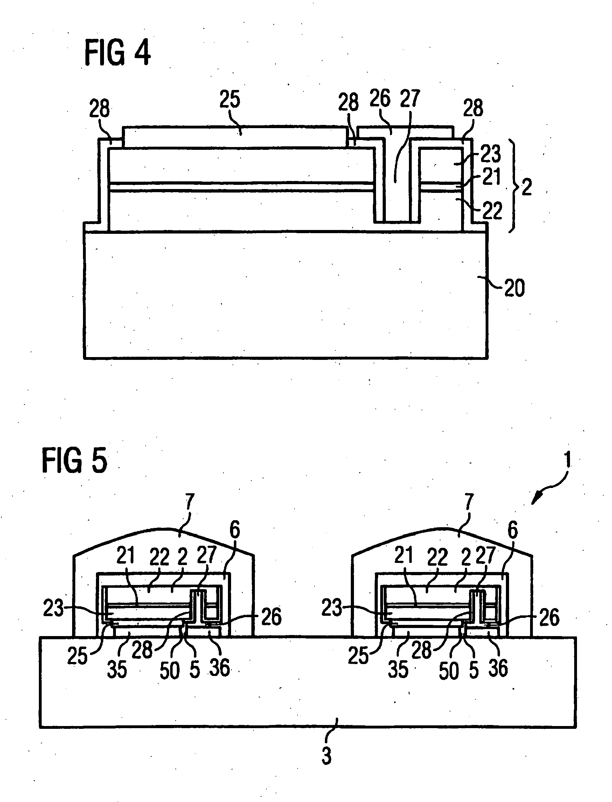

Insbesondere können die Halbleiterkörper 2 und/oder die Aufwachssubstrate 20 wie im Zusammenhang mit Figur 4 beschrieben ausgeführt sein oder zumindest eines der im Zusammenhang mit Figur 4 beschriebenen Merkmale aufweisen.

In einer Ausgestaltungsvariante ist der Hilfsträger 4 als ein starrer Träger ausgeführt.

In einer alternativen Ausgestaltungsvariante ist der Hilfsträger als Folie ausgeführt. Der Hilfsträger kann also mechanisch flexibel sein. Gegebenenfalls kann die Folie durch einen weiteren Träger, insbesondere auf der den Halbleiterkörpern 2 abgewandten Seite, mechanisch stabilisiert werden.

In Figur 1B ist ein Bauelementträgerverbund 30 dargestellt, auf dem Montagebereiche 31 vorgesehen ist. Die Montagebereiche sind jeweils zur Befestigung von Halbleiterkörpern vorgesehen. In den Montagebereichen sind jeweils eine Anschlussfläche 35 und eine weitere Anschlussfläche 36 auf dem Bauelementträgerverbund ausgebildet.

In dem gezeigten Ausführungsbeispiel ist lediglich beispielhaft ein Bauelementträgerverbund 30 dargestellt, aus dem bei der Herstellung der optoelektronischen Bauelemente zwei Bauelementträger hervorgehen, wobei aus den Bauelementträgerverbundbereichen 301 jeweils ein Bauelementträger ausgebildet wird. Auf jedem Bauelementträgerverbundbereich 301 werden jeweils zwei Halbleiterkörper angeordnet. Selbstverständlich können auf einem Bauelementträgerverbundbereich 301 auch eine von zwei abweichende Anzahl von Halbleiterkörpern 2, beispielsweise ein Halbleiterkörper oder drei oder mehr Halbleiterkörper, angeordnet werden. Weiterhin können aus einem Bauelementträgerverbund auch mehr als zwei Bauelementträger hervorgehen.

Der Bauelementträger 3 kann starr oder flexibel ausgeführt sein. Beispielsweise eignet sich eine Leiterplatte, etwa eine PCB(printed circuit board)-Leiterplatte. Auch eine Metallkern-Leiterplatte (MCPCB, metal core printed circuit board) kann Anwendung finden. Eine solche Leiterplatte zeichnet sich insbesondere durch eine hohe Wärmeleitfähigkeit aus. Im Betrieb der optoelektronischen Bauelemente im Halbleiterkörper erzeugte Wärme kann so besonders effizient abgeführt werden.

Alternativ können die Bauelementträger 3 auch eine Keramik enthalten und beispielsweise als Keramikkörper ausgeführt sein, auf denen jeweils elektrisch leitfähige Anschlussflächen vorgesehen sein können. Weiterhin können die Bauelementträger 3 auch als, vorzugsweise metallische, Leiterrahmen ausgeführt sein. In diesem Fall kann der Bauelementträgerverbund 30 beispielsweise ein Metallblech sein, aus dem die Leiterrahmen ausgebildet werden.

Der Hilfsträger 4 wird relativ zum Bauelementträgerverbund 30 derart positioniert, dass die Halbleiterkörper 2 dem Bauelementträgerverbund 30 zugewandt sind (Figur 1C). Dabei kann der Hilfsträger 4 flächig über dem Bauelementträgerverbund 30 angeordnet sein.

Die Positionierung erfolgt zweckmäßigerweise derart, dass die Anschlussflächen 35, 36 in Aufsicht mit den zugehörigen Kontaktflächen 25, 26 der zugehörigen Halbleiterkörper 2A überlappen und vorzugsweise in mechanischem Kontakt zueinander stehen. Zwischen der Anschlussfläche 35 und der Kontaktfläche 25 sowie zwischen der weiteren Anschlussfläche 36 und der weiteren Kontaktfläche 26 wird eine elektrisch leitende Verbindung hergestellt. Dies kann beispielsweise mittels Lötens erfolgen. Alternativ oder ergänzend kann auch ein elektrisch leitfähiger Klebstoff Anwendung finden. Die Halbleiterkörper 2A können so mit dem Bauelementträgerverbund 30 mechanisch stabil verbunden werden.

Die Halbleiterkörper 2 können also beim Herstellen der elektrisch leitenden Verbindung mit den Anschlussflächen 35, 36 auch mechanisch stabil am Bauelementträgerverbund 301 befestigt werden. Alternativ oder ergänzend können die Halbleiterkörper 2 auch separat von der elektrisch leitenden Verbindung, etwa mittels Klebens, am Bauelementträgerverbund befestigt werden.

Zwischen den Halbleiterkörpern 2A ist auf dem Hilfsträger 4 beispielhaft jeweils ein weiterer Halbleiterkörper 2B angeordnet. Diese Halbleiterkörper 2B sind relativ zum Bauelementträgerverbund derart angeordnet, dass sie sich außerhalb der Montagebereiche 31 befinden. Diese Halbleiterkörper 31 werden in dem beschriebenen Verfahrensschritt nicht mit dem Bauelementträgerverbund 30 mechanisch verbunden und verbleiben auf dem Hilfsträger 4. Beispielsweise können die für die Montage vorgesehenen Halbleiterkörper 2A und die auf dem Hilfsträger verbleibenden Halbleiterkörper 2B auf dem Hilfsträger ein schachbrettartiges Muster bilden. Davon abweichend kann auch ein anderes Muster zweckmäßig sein. Zweckmäßigerweise ist das Muster auf die Anordnung der Montagebereiche 31 auf dem Bauelementträgerverbund angepasst. Insbesondere kann das Muster die Anordnung der Montagebereiche nachbilden.

Auf dem Hilfsträger 4 können auf einer Fläche also mehr Halbleiterkörper 2 ausgebildet sein als der Bauelementträgerverbund 30 auf einer Fläche derselben Größe Montagebereiche zur Verfügung stellt. Demnach können die Halbleiterkörper 2 mit einer höheren Packungsdichte auf dem Hilfsträger 4 angeordnet sein als die Montagebereiche auf dem Bauelementträgerverbund.

Zur Bestückung der Bauelementträgerverbundbereiche 301 des Bauelementträgerverbunds 30 werden zweckmäßigerweise jeweils diejenigen Halbleiterkörper 2A mit dem Bauelementträgerverbund 30 mechanisch stabil verbunden, die innerhalb eines Montagebereichs 31 auf dem Bauelementträgerverbund liegen, wobei insbesondere deren Kontaktflächen 25, 26 mit Anschlussflächen auf dem Bauelementträgerverbund 30 überlappen können. Mit anderen Worten können aus den Halbleiterkörpern 2, die auf dem Hilfsträger 4 mit einer größeren Packungsdichte angeboten werden, diejenigen Halbleiterkörper für die Montage auf dem Bauelementträgerverbund 30 selektiert werden, die geeignet relativ zu den Montagebereichen 31 positioniert sind.

Die Halbleiterkörper 2A mit den zugeordneten Aufwachssubstratkörpern 20 werden nachfolgend von dem Hilfsträger 4 selektiv entfernt (Figur 1D). Die Halbleiterkörper 2B dagegen verbleiben mit dem Hilfsträger 4 mechanisch verbunden und können mit dem Hilfsträger 4 von dem Bauelementträgerverbund 30 entfernt werden.

Das selektive Ablösen der Halbleiterkörper 2A vom Hilfsträger 4 kann beispielsweise durch lokales Verändern der Hafteigenschaften des Hilfsträgers 4 erfolgen. Insbesondere eignet sich ein Hilfsträger, dessen Hafteigenschaften mittels Belichtens lokal verringert werden können. Hierfür ist beispielsweise elektromagnetische Strahlung, insbesondere kohärente Strahlung, etwa Laserstrahlung, geeignet, welche gezielt auf den Hilfsträger in dem Bereich der abzulösenden Halbleiterkörper 2A auf den Hilfsträger eingestrahlt wird. Der Hilfsträger 4 kann beispielsweise eine Folie sein, deren Hafteigenschaften zum Halbleiterkörper beziehungsweise dem zugehörigen Aufwachssubstratkörper mittels Belichtens verringert werden kann.

Die Anschlussfläche 35 und die weitere Anschlussfläche 36 sind zweckmäßigerweise voneinander beabstandet. Bei der Befestigung der Halbleiterkörper 2 an dem Bauelementträger kann zwischen den Halbleiterkörpern und dem Bauelementträgerverbund 30 jeweils ein Zwischenraum 5 entstehen (Figur 1C). Diese Zwischenräume 5 können mittels eines Füllmaterials 50 zumindest bereichsweise aufgefüllt werden. Das Füllmaterial ist vorzugsweise derart ausgeführt, dass Kapillareffekte das Eindringen des Füllmaterials in die Zwischenräume 5 begünstigen.

Das Füllmaterial wird zweckmäßigerweise in fließfähigem Zustand in den Zwischenraum eingebracht. Vorzugsweise weist das Füllmaterial eine niedrige Viskosität auf. Das Eindringen in kleine Zwischenräume wird dadurch erleichtert. Nachfolgend kann das Füllmaterial erforderlichenfalls gehärtet werden. Das Härten kann beispielsweise thermisch induziert oder mittels elektromagnetischer Strahlung, insbesondere ultravioletter Strahlung, induziert werden. Weiterhin ist das Füllmaterial vorzugsweise elektrisch isolierend ausgeführt.

Das Füllmaterial 50 enthält vorzugsweise ein organisches Material, etwa ein Harz, insbesondere ein Reaktionsharz. Beispielsweise kann das Füllmaterial ein Epoxidharz enthalten. Weiterhin kann das Füllmaterial als ein Klebstoff ausgeführt sein.

Wie in Figur 1E dargestellt, können die Aufwachssubstratkörper 20 von den jeweiligen Halbleiterkörpern 2 entfernt werden. Das Füllmaterial 50 dient hierbei der mechanischen Stabilisierung des Halbleiterkörpers 2.

Das Entfernen der Aufwachssubstratkörper 20 kann vollständig oder teilweise erfolgen. Bevorzugt findet ein Laserablöseverfahren Anwendung. Alternativ können die Aufwachssubstratkörper auch mittels eines chemischen Prozesses, etwa nasschemischen oder trockenchemischen Ätzens, und/oder eines mechanischen Prozesses, etwa Schleifens, Läppens oder Polierens, gedünnt oder vollständig entfernt werden. Das von den Halbleiterkörpern gelöste Material der Aufwachssubstratkörper 20 kann beispielsweise abgesaugt werden.

Während der Herstellung der optoelektronischen Bauelemente dienen die Aufwachssubstratkörper 20 der mechanischen Stabilisierung der jeweiligen Halbleiterkörper 2. Eine weitergehende Stabilisierung mittels eines zusätzlichen Trägers ist hierfür nicht erforderlich. Bei dem beschriebenen Verfahren werden die Aufwachssubstratkörper 20 entfernt, nachdem die Halbleiterkörper 2 bereits auf dem Bauelementträgerverbund, aus dem Bauelementträger hervorgehen, befestigt sind.

Im fertig gestellten optoelektronischen Bauelement 1 müssen die Aufwachssubstratkörper dagegen nicht mehr vorhanden sein (Figur 1H). Das Aufwachssubstrat für die Halbleiterschichtenfolge der Halbleiterkörper 2 kann somit weitgehend unabhängig von den optoelektronischen Eigenschaften gewählt werden.

Weiterhin können die Halbleiterkörper 2 im fertig gestellten optoelektronischen Bauelement 1 durch den Bauelementträger 3 mechanisch stabilisiert werden. Auf einen zusätzlichen Träger, etwa auf der dem Bauelementträger abgewandten Seite des Halbleiterkörpers, kann verzichtet werden. Dadurch kann die Bauhöhe des optoelektronischen Bauelements 1 verringert werden.

Wie in Figur 1F dargestellt, können die Halbleiterkörper 2 mit einer Struktur 29 versehen werden, durch die die Auskoppeleffizienz aus den Halbleiterkörpern gesteigert wird. Der Anteil von Strahlung, der im Betrieb der optoelektronischen Bauelemente in den jeweiligen aktiven Bereichen erzeugt wird und aus den Halbleiterkörpern austritt, kann so gesteigert werden.

Die Strukturierung der Halbleiterkörper 2 oder einer auf den Halbleiterkörpern angeordneten Schicht kann beispielsweise mechanisch, etwa mittels Schleifens, Läppens, Polierens, oder chemisch, etwa mittels nasschemischen oder trockenchemischen Ätzens, erfolgen. Die Struktur kann hierbei unregelmäßig oder regelmäßig ausgeführt sein. Mehrfachreflexion von Strahlung an Grenzflächen des Halbleiterkörpers infolge von Totalreflexion kann mittels der Struktur vermindert werden. Weiterhin kann die Struktur gemäß einem photonischen Kristall geformt sein.

Um die spektrale Charakteristik des herzustellenden optoelektronischen Bauelements zu beeinflussen, kann auf dem Halbleiterkörper 2 ein Strahlungskonversionsstoff, etwa ein Lumineszenzkonverter oder ein Phosphor, ausgebildet werden. Der Strahlungskonversionsstoff kann beispielsweise in einer Umhüllung 6 für den Halbleiterkörper 2 ausgebildet sein. Im Halbleiterkörper 2 erzeugte Strahlung kann zumindest teilweise von dem Strahlungskonversionsstoff in Strahlung anderer Wellenlänge umgewandelt werden. Auf diese Weise kann mischfarbiges Licht, vorzugsweise für das menschliche Auge weiß erscheinendes Licht, von dem optoelektronischen Bauelement abgestrahlt werden.

Davon abweichend kann der Strahlungskonversionsstoff auch in einer von der Umhüllung 6 verschiedenen, separaten Schicht ausgebildet sein, die auf der dem Bauelementträgerverbund 30 abgewandten Seite auf die Halbleiterkörper aufgebracht werden kann. Die Umhüllung kann beispielsweise ein Harz, insbesondere ein Reaktionsharz oder ein Silikon enthalten.

Insbesondere kann die spektrale Charakteristik der von Halbleiterkörpern abgestrahlten Strahlung vor dem Aufbringen des Strahlungskonversionsstoffs gemessen werden und die Menge und/oder Zusammensetzung des Strahlungskonversionsstoffs basierend auf den Messergebnissen eingestellt werden. Auf diese Weise kann beispielsweise der Farbort des optoelektronischen Bauelements im CIE-Diagramm besonders genau eingestellt werden.

Weiterhin kann die Menge und/oder die Zusammensetzung des Strahlungskonversionsstoffs selektiv an den jeweiligen Halbleiterkörper angepasst werden. Die Menge und/oder Zusammensetzung können also von Halbleiterkörper zu Halbleiterkörper weitgehend unabhängig voneinander eingestellt werden.

Das Aufbringen des Strahlungskonversionsstoffs kann beispielsweise für jeden Halbleiterkörper einzeln mittels eines Mikrodosierers erfolgen.

Entsprechend kann erforderlichenfalls auch die Helligkeit der optoelektronischen Bauelemente 1, insbesondere nach Maßgabe einer zuvor durchgeführten Messung der von dem jeweiligen Halbleiterkörper abgestrahlten Strahlungsleistung, eingestellt und so an einen vorgegebenen Wert angepasst werden. Hierfür kann auf dem Halbleiterkörper beispielsweise eine Schicht aufgebracht werden, die einen Teil der vom Halbleiterkörper abgestrahlten Strahlung gezielt absorbiert.

Weitergehend kann die Umhüllung 6 gemäß einem optischen Element 7 geformt sein. In diesem Fall wird das optische Element also auf dem Halbleiterkörper 2 ausgebildet. Davon abweichend kann das optische Element auch vorgefertigt sein und an dem Bauelement befestigt werden. Insbesondere kann das optische Element als Linse oder als Lichtleiter ausgeführt sein. Zweckmäßigerweise ist das optische Element aus einem Material gefertigt, das für in den Halbleiterkörpern erzeugte Strahlung transparent oder zumindest transluzent ist. Beispielsweise kann das optische Element 7 auf Kunststoff, einem Silikon oder Glas basieren oder aus einem solchen Material bestehen.

Aus dem Bauelementträgerverbund 30 werden die Bauelementträger 3 ausgebildet. Dies kann beispielsweise mittels mechanischen Trennens, etwa Sägens, Schneidens, Spaltens, Stanzens oder Brechens, oder mittels kohärenter Strahlung, etwa Laserstrahlung, erfolgen. Zwei fertig gestellte optoelektronische Bauelemente 1 sind in Figur 1H dargestellt.

Bei dem beschriebenen Verfahren kann also eine Vielzahl von Herstellungsschritten durchgeführt werden, bevor die Bauelementträger 3 aus dem Bauelementträgerverbund 30 ausgebildet werden. Die Herstellung der optoelektronischen Bauelemente 1 wird dadurch vereinfacht. Insbesondere können Halbleiterkörper 2 mit jeweils einem Aufwachssubstratkörper 20 in dem Bauelementträgerverbund 30 montiert werden. Die Aufwachssubstratkörper 20 können nachfolgend entfernt werden, so dass die optoelektronischen Bauelemente 1 frei von den Aufwachssubstratkörpern sein können.

Von dem beschriebenen Verfahren abweichend können die Halbleiterkörper 2 anstelle der im Zusammenhang mit den Figuren 1C und 1D beschriebenen Verfahrensschritte auch einzeln auf dem Bauelementträgerverbund positioniert und nachfolgend befestigt werden. Die Positionierung kann beispielsweise in einem Pick-and-Place-Verfahren erfolgen. Die weiteren Verfahrensschritte, insbesondere das im Zusammenhang mit Figur 1E beschriebene Entfernen der Aufwachssubstratkörper, können wie oben beschrieben durchgeführt werden. Die jeweiligen Aufwachssubstratkörper 20 können bei dieser Variante während der Montage der Halbleiterkörper der mechanischen Stabilisierung der Halbleiterkörper dienen und weiterhin nachfolgend entfernt werden.

Die beschriebenen Verfahrensschritte werden vorzugsweise in einer Vorrichtung für eine Vielzahl von optoelektronischen Bauelementen durchgeführt. Insbesondere können die Verfahrensschritte vollautomatisch oder zumindest teilautomatisiert durchgeführt werden. Die Herstellung der optoelektronischen Bauelemente wird so weitergehend vereinfacht.

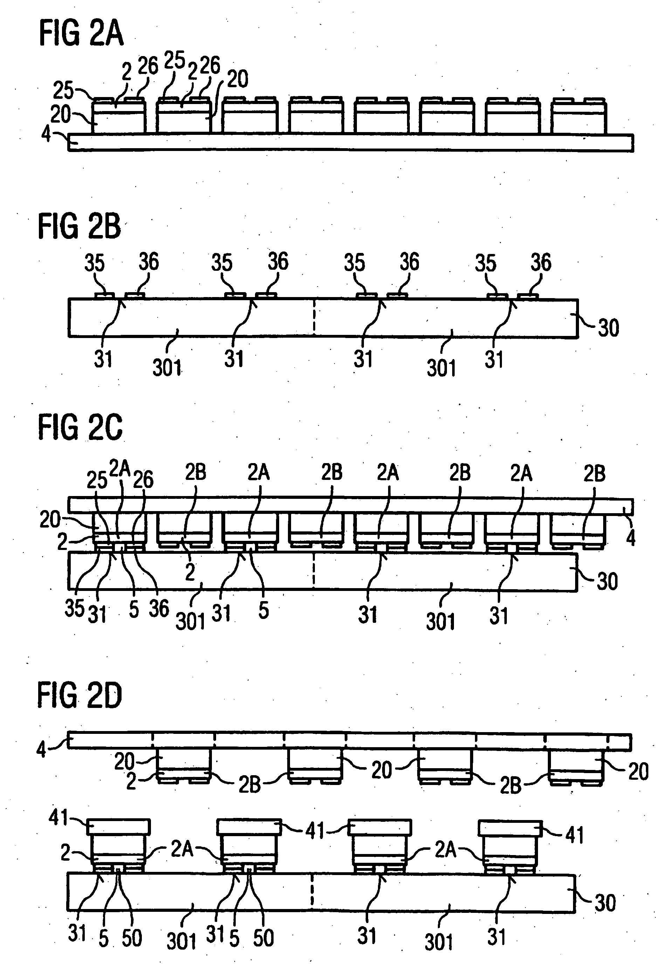

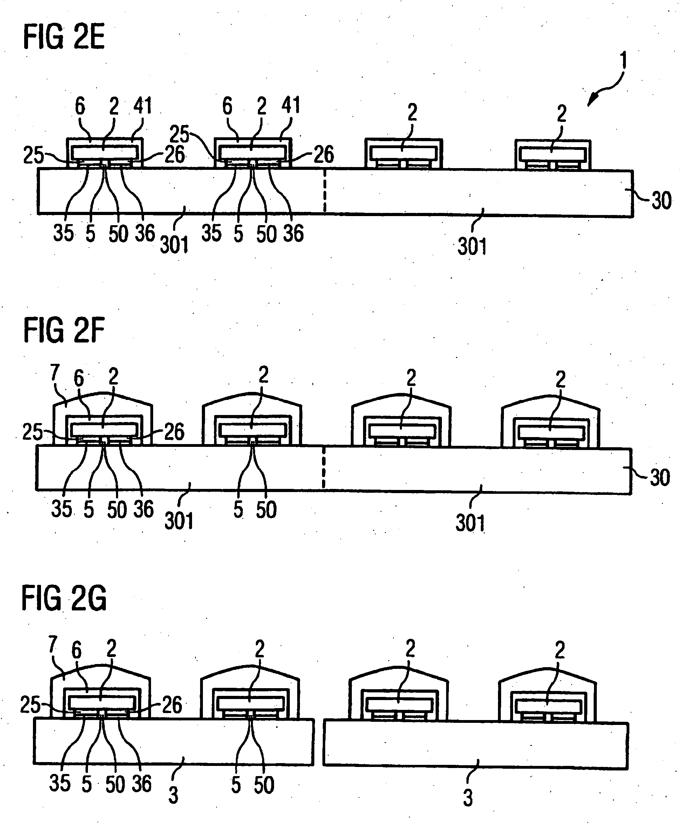

Ein zweites Ausführungsbeispiel für ein Verfahren zur Herstellung einer Mehrzahl von Halbleiterchips ist in den Figuren 2A bis 2G schematisch in Schnittansicht anhand von Zwischenschritten dargestellt. Das zweite Ausführungsbeispiel entspricht im Wesentlichen dem im Zusammenhang mit den Figuren 1A bis 1H beschriebenen ersten Ausführungsbeispiel. Im Unterschied dazu verbleibt ein Teil 41 des Hilfsträgers 4 an den Halbleiterkörpern 2A, die an dem Bauelementträgerverbund 30 befestigt sind. Dies ist in Figur 2D gezeigt. Mittels dieser Teile des Hilfsträgers 4 kann, wie in Figur 2E gezeigt, eine Umhüllung 6 für die Halbleiterkörper 2 gebildet werden.

Mittels der Umhüllung können die Halbleiterkörper 2 verkapselt und so vor äußeren Einflüssen geschützt werden. Alternativ oder ergänzend kann mittels dieser Teile des Hilfsträgers auch jeweils ein Gehäusekörper für die Halbleiterkörper 2 gebildet werden. Beispielsweise kann der Hilfsträger mittels einer Folie gebildet sein, die an die Halbleiterkörper 2 angeformt werden kann. Dieses Anformen kann beispielsweise thermisch induziert erfolgen. Beispielsweise können die Halbleiterkörper zusammen mit dem Bauelementträgerverbund 30 auf eine Temperatur oberhalb des Schmelzpunkts der Folie erhitzt werden. Alternativ kann die Folie auch lokal, beispielsweise mittels kohärenter Strahlung, etwa Laserstrahlung, erhitzt werden.

Weiterhin wird im Unterschied zum ersten Ausführungsbeispiel ein vorgefertigtes optisches Element 7 an dem Bauelementträgerverbund 30 befestigt. Das optische Element ist beispielhaft als Plankonvexlinse ausgeführt. Davon abweichend kann, je nach der zu erzielenden Abstrahlcharakteristik auch eine andere Form für das optische Element vorteilhaft sein. Das optische Element 7 kann beispielsweise mittels Klebens an dem Bauelementträger 3 befestigt werden.

Wie im Zusammenhang mit den Figuren 1A bis 1H beschrieben kann auf den Halbleiterkörpern, insbesondere auf der Umhüllung 6, ein Strahlungskonversionsstoff aufgebracht werden (nicht explizit dargestellt).

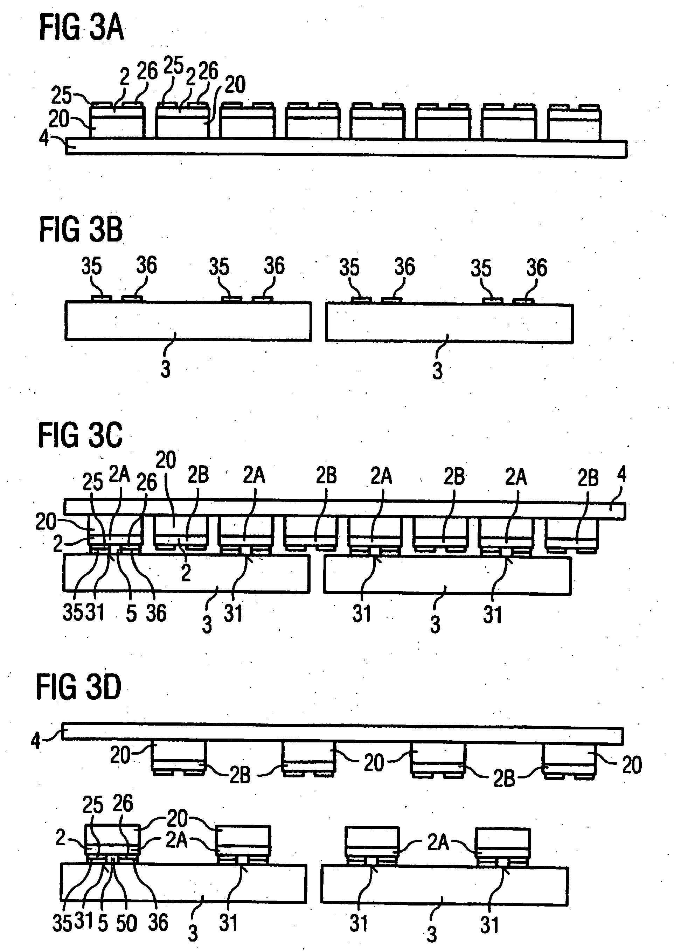

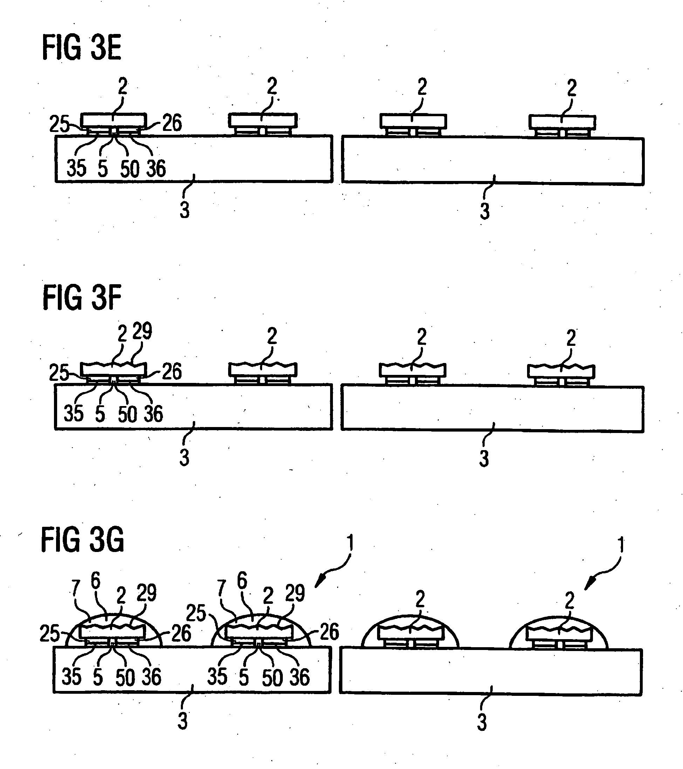

Ein drittes Ausführungsbeispiel für ein Verfahren zur Herstellung einer Mehrzahl von Halbleiterchips ist in den Figuren 3A bis 3G schematisch in Schnittansicht anhand von Zwischenschritten dargestellt. Das dritte Ausführungsbeispiel entspricht im Wesentlichen dem im Zusammenhang mit den Figuren 1A bis 1H beschriebenen ersten Ausführungsbeispiel.

Im Unterschied zum ersten Ausführungsbeispiel werden, wie in Figur 3B dargestellt, die Bauelementträger 3 bereits vorgefertigt bereitgestellt. Hierfür können die Bauelementträger auf einem Montageträger angeordnet sein (nicht explizit dargestellt). Die Bauelementträger 3 werden also nicht in einem Bauelementträgerverbund bereitgestellt. Die Bauelementträger 3 weisen entsprechend den Bauelementträgerverbundbereichen 301 exemplarisch jeweils zwei Montagebereiche 31 auf. In den Montagebereichen sind jeweils eine Anschlussfläche 35 und eine weitere Anschlussfläche 36 auf den Bauelementträgern 3 ausgebildet. Die Bauelementträger 3 können jeweils auch eine davon abweichende Anzahl von Montagebereichen etwa einen Montagebereich oder mehr als zwei Montagebereiche aufweisen.

Die weiteren Herstellungsschritte, die in den Figuren 3A sowie 3C bis 3G dargestellt sind, können wie im Zusammenhang mit den Figuren 1A sowie 1C bis 1G beschrieben durchgeführt werden. Die Bauelementträger 3 entsprechen hierbei im Wesentlichen den Bauelementträgerverbundbereichen 301 des ersten Ausführungsbeispiels. Insbesondere werden die den Montagebereichen 31 zugeordneten Halbleiterkörper 2 an den jeweiligen Bauelementträgern 3 befestigt (Figur 3D).

Entsprechend dem im Zusammenhang Figuren 1A bis 1H beschriebenen ersten Ausführungsbeispiel können die Zwischenräume 50, die sich zwischen den Halbleiterkörpern 2 und den Bauelementträgern 3 beim Befestigen der Halbleiterkörper an den Bauelementträgern ausbilden können, gefüllt werden.

Vom gezeigten dritten Ausführungsbeispiel abweichend können auch die im Zusammenhang mit den Figuren 2A bis 2G beschriebenen zweiten Ausführungsbeispiel genannten Merkmale Anwendung finden. Insbesondere können die optischen Elemente 7 vorgefertigt sein. Weiterhin kann jeweils ein Teil des Hilfsträgers 4 an den Halbleiterkörpern 2 verbleiben.

Im Unterschied zum ersten Ausführungsbeispiel ist das in Figur 1H dargestellte Ausbilden der Bauelementträger aus einem Bauelementträgerverbund bei einem Verfahren gemäß dem dritten Ausführungsbeispiel nicht erforderlich.

Von dem beschriebenen Verfahren gemäß dem dritten Ausführungsbeispiel abweichend können die Halbleiterkörper 2 anstelle der in den Figuren 3C und 3D dargestellten Verfahrensschritte auch einzeln auf den Bauelementträgern positioniert und nachfolgend befestigt werden. Die Positionierung kann beispielsweise in einem Pick-and-Place-Verfahren erfolgen. Die weiteren Verfahrensschritte, insbesondere das im Zusammenhang mit Figur 3E beschriebene Entfernen der Aufwachssubstratkörper, können wie oben beschrieben durchgeführt werden. Die jeweiligen Aufwachssubstratkörper 20 können bei dieser Variante während der Montage der Halbleiterkörper der mechanischen Stabilisierung der Halbleiterkörper dienen und weiterhin nachfolgend entfernt werden.

In Figur 4 ist in schematischer Schnittansicht ein Ausführungsbeispiel für einen Halbleiterkörper 2 gezeigt, der für die anhand der Figuren 1A bis 1H, 2A bis 2G beziehungsweise 3A bis 3G beschriebenen Ausführungsbeispiele des Verfahrens besonders geeignet ist.

Der Halbleiterkörper 2 ist beispielhaft als ein Lumineszenzdioden-Halbleiterkörper ausgeführt, der zur Erzeugung von inkohärenter Strahlung vorgesehen ist. Eine Halbleiterschichtenfolge, die einen aktiven Bereich 21, eine n-leitende Halbleiterschicht 22 und eine p-leitende Halbleiterschicht 23 aufweist, bildet den Halbleiterkörper 2. Die Halbleiterschichtenfolge des Halbleiterkörpers 2 ist auf einem Aufwachssubstratkörper 20 angeordnet. Die Aufwachssubstratkörper 20 gehen vorzugsweise durch Vereinzeln aus einem Aufwachssubstrat, etwa einem Wafer, hervor. Auf dem Aufwachssubstrat kann die Halbleiterschichtenfolge, aus der die Halbleiterkörper 2 gebildet werden, vorzugsweise epitaktisch, etwa mittels MOVPE oder MBE, hergestellt werden.

Der Halbleiterkörper 2, insbesondere der aktive Bereich 21, enthält bevorzugt ein III-V-Halbleitermaterial. III-V-Halbleitermaterialien sind zur Strahlungserzeugung im ultravioletten (Inₓ Ga_{y} Al_{1-x-y} N) über den sichtbaren (Inₓ Ga_{y} Al_{1-x-y} N, insbesondere für blaue bis grüne Strahlung, oder Inₓ Ga_{y} Al_{1-x-y} P, insbesondere für gelbe bis rote Strahlung) bis in den infraroten (Inₓ Ga_{y} Al_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung vorteilhaft hohe interne Quanteneffizienzen erzielt werden.

Als Aufwachswachssubstrat kann, abhängig von dem für den Halbleiterkörper abzuscheidenden Material beispielsweise ein Halbleitersubstrat, etwa ein Substrat, das GaAs, Si, SiC, GaN, InP oder GaP enthält oder aus einem solchen Material besteht, verwendet werden. Auch ein Saphirsubstrat kann Anwendung finden.

Die n-leitende Halbleiterschicht 22 ist zwischen dem aktiven Bereich und dem Aufwachssubstratkörper 20 angeordnet. Die Anordnung der n-leitenden Halbleiterschicht und der p-leitenden Halbleiterschicht 23 bezüglich des aktiven Bereichs 21 kann aber auch vertauscht sein, sodass die p-leitende Halbleiterschicht zwischen dem aktiven Bereich 21 und dem Aufwachssubstratkörper 20 angeordnet sein kann.

Auf der dem Aufwachssubstratkörper 20 abgewandten Seite des aktiven Bereichs 21 sind eine Kontaktfläche 25 und eine weitere Kontaktfläche 26 ausgebildet. Die Kontaktfläche 25 und die weitere Kontaktfläche 26 sind also auf derselben Seite des aktiven Bereichs angeordnet. Die externe elektrische Kontaktierung des Halbleiterkörpers kann also von einer Seite des Halbleiterkörpers, insbesondere von einer Seite des aktiven Bereichs, aus erfolgen.

Die Kontaktflächen 25, 26 sind zweckmäßigerweise elektrisch leitend ausgeführt. Bevorzugt enthalten die Kontaktflächen ein Metall, etwa Au, Sn, Ni, Ti, Al oder Pt, oder eine metallische Legierung mit zumindest einem der genannten Metalle, etwa AuSn oder AuGe. Die Kontaktflächen können beispielsweise mittels Aufsputterns oder Aufdampfens auf den Halbleiterkörper hergestellt werden.

Weiterhin weist der Halbleiterkörper 2 zumindest eine Ausnehmung 27 auf, die sich von der dem Aufwachssubstratkörper 20 abgewandten Seite des Halbleiterkörpers 2 ausgehend durch den aktiven Bereich 21 hindurch erstreckt.

In der Ausnehmung 27 ist der Halbleiterkörper 2 an den Seitenflächen der Ausnehmung mit einer Isolationsschicht 28 versehen. Weiterhin ist die Isolationsschicht zwischen der weiteren Kontaktfläche 26 und dem Halbleiterkörper ausgebildet. Die Isolationsschicht kann beispielsweise ein Oxid, etwa Siliziumoxid, ein Nitrid, etwa Siliziumnitrid oder ein Oxinitrid, etwa Siliziumoxinitrid, enthalten.

Durch die Ausnehmung 27 hindurch wird auf der Isolationsschicht 28 eine elektrisch leitende Verbindung der weiteren Kontaktfläche 26 mit der n-leitenden Halbleiterschicht 22 hergestellt. Durch Anlegen einer externen elektrischen Spannung zwischen der Kontaktfläche 25 und der weiteren Kontaktfläche 26 kann also ein Strom durch den aktiven Bereich 21 fließen und dort zur Erzeugung von elektromagnetischer Strahlung durch Rekombination von Elektron-Loch-Paaren führen.

Auf der dem Halbleiterkörper 2 abgewandten Seite bilden die Kontaktfläche 25 und die weitere Kontaktfläche 26 bevorzugt eine ebene Fläche. So kann der Halbleiterkörper 2 vereinfacht an einem Bauelementträger befestigt werden.

Vom gezeigten Ausführungsbeispiel abweichend kann der Halbleiterkörper 2 auch zwei oder mehr Ausnehmungen zur Kontaktierung der n-leitenden Halbleiterschicht 22 aufweisen. Eine in lateraler Richtung gleichmäßige Einprägung von Ladungsträgern in den aktiven Bereich 21 kann dadurch vereinfacht werden.

In Figur 5 ist ein Ausführungsbeispiel für ein optoelektronisches Bauelement in schematischer Schnittansicht dargestellt.

Das optoelektronische Bauelement 1 umfasst einen Bauelementträger 3. An dem Bauelementträger sind zwei Halbleiterkörper 2 befestigt. Die Halbleiterkörper 2, auf denen jeweils eine Kontaktfläche 25 und eine weitere Kontaktfläche 26 angeordnet sind, sind jeweils wie im Zusammenhang mit Figur 4 beschrieben ausgeführt. Insbesondere bildet eine Halbleiterschichtenfolge, die einen zur Erzeugung von Strahlung vorgesehenen aktiven Bereich 21 aufweist, den Halbleiterkörper 2. Die jeweiligen Aufwachssubstratkörper 20, auf denen der Halbleiterkörper wie im Zusammenhang mit Figur 4 beschrieben ausgebildet ist, sind in dem in Figur 5 gezeigten fertig gestellten optoelektronischen Bauelement von den Halbleiterkörpern vollständig entfernt. Davon abweichend können die Aufwachssubstratkörper auch nur bereichsweise entfernt oder gedünnt sein.

Die Kontaktfläche 25 und die weitere Kontaktfläche 26 sind jeweils mit einer Anschlussfläche 35 und einer weiteren Anschlussfläche 36 des Bauelementträgers elektrisch leitend verbunden. Zwischen dem Halbleiterkörper 2 und dem Bauelementträger 3 ist ein Zwischenraum 5 ausgebildet. Der Zwischenraum ist in lateraler Richtung bereichsweise von den Anschlussflächen 35, 36 und/oder den Kontaktflächen 25, 26 begrenzt.

Der Zwischenraum 5 ist mit einem Füllmaterial 50 gefüllt. Das Füllmaterial dient insbesondere der mechanischen Stabilisierung des Halbleiterkörpers 2. Der Halbleiterkörper 2 kann so, insbesondere während der Herstellung des optoelektronischen Bauelements 1, höheren mechanischen Belastungen standhalten. Die Herstellung des optoelektronischen Bauelements 1 wird dadurch vereinfacht.

Von dem gezeigten Ausführungsbeispiel abweichend kann der Zwischenraum 5 auch nur teilweise mit dem Füllmaterial gefüllt sein, wobei das Füllmaterial zweckmäßigerweise den Halbleiterkörper 2 hinreichend mechanisch stabilisiert.

Die Halbleiterkörper 2 sind von einer Umhüllung 6 umgeben, die die Halbleiterkörper vorzugsweise verkapselt. Mittels der Umhüllung können die Halbleiterkörper jeweils vor äußeren Einflüssen wie Feuchtigkeit geschützt werden.

Wie im Zusammenhang mit den Figuren 1A bis 1H beschrieben, kann in die Umhüllung 6 ein Strahlungskonversionsstoff eingebettet sein. Alternativ oder ergänzend kann der Strahlungskonversionsstoff auch in einer von der Umhüllung 6 separaten Schicht ausgebildet sein.

Weiterhin kann zumindest einer der Halbleiterkörper wie im Zusammenhang mit Figur 1F beschrieben mit einer Struktur versehen sein.

Die weiteren Elemente des optoelektronischen Bauelements 1, insbesondere der Bauelementträger 3, die Anschlussflächen 35, 36 und das optische Element 7, können wie im Zusammenhang mit den Figuren 1A bis 1H, 2A bis 2G und 3A bis 3G beschrieben ausgeführt sein.

## Patentansprüche

1. Verfahren zur Herstellung einer Mehrzahl von optoelektronischen Bauelementen (1) mit den Schritten:
a) Bereitstellen einer Mehrzahl von Halbleiterkörpern (2) mit jeweils einer Halbleiterschichtenfolge auf einem Hilfsträger (4), der als eine Folie ausgeführt ist, wobei die Halbleiterkörper (2) jeweils auf einem Aufwachssubstratkörper (20) für die Halbleiterschichtenfolge des Halbleiterkörpers (2) ausgebildet sind;
b) Bereitstellen einer Mehrzahl von Bauelementträgern (3) in einem Bauelementträgerverbund (30), die jeweils zumindest eine Anschlussfläche (35) aufweisen;
c) Positionieren der Halbleiterkörper relativ zu den Bauelementträgern (3);
d) Herstellen einer elektrisch leitenden Verbindung der Anschlussflächen (35) der Bauelementträger (3) mit den den Anschlussflächen (35) zugeordneten Halbleiterkörpern (2) und Befestigen dieser Halbleiterkörper (2) an dem Bauelementträger (3), wobei die Halbleiterkörper (2) durch Verringerung der Hafteigenschaften der Folie mittels elektromagnetischer Strahlung selektiv vom Hilfsträger (4) gelöst werden;
e) Fertigstellen der Mehrzahl von optoelektronischen Bauelementen (1), wobei die Aufwachssubstratkörper (20) von den jeweiligen Halbleiterkörpern (2) vollständig oder nur teilweise entfernt werden und der Bauelementträgerverbund (30) in die Bauelementträger vereinzelt wird.

2. Verfahren nach Anspruch 1,
bei dem der Hilfsträger (4) in Schritt c) derart relativ zu den Bauelementträgern (3) positioniert wird, dass die Halbleiterkörper (2) den Bauelementträgern (3) zugewandt sind und
- in Schritt a) auf dem Hilfsträger (4) zwischen zwei Halbleiterkörpern (2), die in Schritt d) nebeneinander auf Bauelementträgern (3) befestigt werden, zumindest ein weiterer Halbleiterkörper (2) angeordnet ist.

3. Verfahren nach Anspruch 2,
bei dem der Hilfsträger (4) in Schritt a) mit separaten Halbleiterkörpern (2) versehen ist, die bezüglich ihrer optoelektronischen Eigenschaften vorselektiert sind.

4. Verfahren nach einem der Ansprüche 1 bis 3,
bei dem ein Teil der Folie im fertig gestellten optoelektronischen Bauelement an dem Halbleiterkörper (20) verbleibt.

5. Verfahren nach einem der Ansprüche 1 bis 4,
bei dem in Schritt b) auf den Bauelementträgern (3) jeweils zumindest ein Montagebereich (31) ausgebildet ist, der zur Befestigung eines Halbleiterkörpers (2) vorgesehen ist und bei dem Halbleiterkörper (2A) vom Hilfsträger (4) getrennt werden, welche in Schritt c) jeweils innerhalb eines Montagebereichs (31) angeordnet werden und Halbleiterkörper (2B), welche außerhalb der Montagebereiche (31) angeordnet sind, auf dem Hilfsträger (4) verbleiben.

6. Verfahren nach einem der Ansprüche 1 bis 5,
bei dem eine optoelektronische Eigenschaft von zumindest einem optoelektronischen Bauelement nach dem Befestigen des jeweiligen Halbleiterkörpers an dem Bauelementträger eingestellt wird.

7. Verfahren nach einem der Ansprüche 1 bis 6,
bei dem auf den Halbleiterkörpern ein Strahlungskonversionsstoff ausgebildet wird, wobei die Menge und/oder die Zusammensetzung des Strahlungskonversionsstoffs selektiv an den jeweiligen Halbleiterkörper angepasst wird.

8. Verfahren nach Anspruch 7,
bei dem nach der Befestigung des Halbleiterkörpers an dem Bauelementträgerverbund eine Messung der Helligkeit und/oder des Farborts durchgeführt wird.

9. Verfahren nach einem der Ansprüche 1 bis 8,
bei dem die Halbleiterkörper mittels selektiver Belichtung des Hilfsträgers durch Laserstrahlung von dem Hilfsträger gelöst werden.

## Claims

1. Method of producing a plurality of optoelectronic components (1), comprising the steps:
a) providing a plurality of semiconductor bodies (2) with in each case a semiconductor layer sequence, wherein the semiconductor bodies (2) are arranged on an auxiliary carrier, which is formed as a film, and the semiconductor bodies (2) are formed in each case on a growth substrate body (20) for the semiconductor layer sequence of the semiconductor body (2);
b) providing a plurality of component carriers (3) within a component carrier assembly (30), wherein the component carriers (3) comprise in each case at least one connection pad (35);
c) positioning the semiconductor bodies relative to the component carriers (3);
d) producing an electrically conductive connection between the connection pads (35) of the component carriers (3) and the semiconductor bodies (2) assigned to the connection pads (35) and attaching these semiconductor bodies (2) to the component carrier (3), wherein semiconductor bodies (2) are selectively detached from the auxiliary carrier (4) by reducing the adhesive properties of the film by means of electromagnetic radiation;
e) finishing the plurality of optoelectronic components (1), wherein the growth substrate bodies (20) are removed completely or only partially from the respective semiconductor bodies (2) and the component carrier assembly (30) is singulated into the component carriers.

2. Method according to claim 1,
in which in step c) the auxiliary carrier (4) is positioned in such a way relative to the component carriers (3) that the semiconductor bodies (2) face the component carrier (3), and
- in step a) at least one further semiconductor body (2) is arranged on the auxiliary carrier (4) between two semiconductor bodies (2) which in step d) are attached next to one another on the component carrier assembly (30).

3. Method according to claim 2,
in which in step a) the auxiliary carrier (4) is provided with separate semiconductor bodies (2), which have been preselected with regard to their optoelectronic properties.

4. Method according to one of claims 1 to 3,
in which, in the finished optoelectronic component, a part of the film remains on the semiconductor body (20).

5. Method according to one of claims 1 to 4,
in which in step b) at least one mounting region (31) is formed on the component carrier (3), which mounting region is provided for the attachment of a semiconductor body (2), and in which semiconductor bodies (2A) which in step c) are arranged in each case inside a mounting region (31) are separated from the auxiliary carrier (4) and semiconductor bodies (2B) which are arranged outside the mounting regions (31) remain on the auxiliary carrier (4).

6. Method according to one of claims 1 to 5,
in which an optoelectronic property of at least one optoelectronic component is set after the respective semiconductor body has been attached to the component carrier.

7. Method according to one of claims 1 to 6,
in which a radiation conversion material is formed on the semiconductor body, wherein the quantity and/or composition of the radiation conversion material is selectively adapted to the respective semiconductor body.

8. Method according to claim 7,
in which a measurement of the brightness and/or the color locus is performed after attachment of the semiconductor body to the component carrier assembly

9. Method according to one of claims 1 to 8,
in which the semiconductor bodies are detached from the auxiliary carrier by selectively exposing the auxiliary carrier to laser radiation.

## Revendications

1. Procédé de fabrication d'une pluralité d'éléments de construction optoélectroniques (1) avec les étapes de:
a) fournir une pluralité de corps semiconducteurs (2) avec respectivement une succession de couches semiconductrices sur un support auxiliaire (4), qui est réalisé comme un film, les corps semiconducteurs (2) étant constitués respectivement sur un corps de substrat de croissance (20) pour la succession de couches semiconductrices de corps semiconducteur (2);
b) fournir une pluralité de supports d'éléments de construction (3) dans un groupement de supports d'éléments de construction (30) qui présentent respectivement au moins une surface de plage de connexion (35);
c) positionnement des corps semiconducteurs par rapport aux supports d'éléments de construction (3);
d) établissement d'une connexion électriquement conductrice des surfaces de plage de connexion (35) des supports d'éléments de construction (3) avec les corps semiconducteurs (2) affectés aux surfaces de plage de connexion (35) et fixation de ces corps semiconducteurs (2) au support d'éléments de construction (3), les corps semiconducteurs (2) étant détachés sélectivement du support auxiliaire (4) par réduction des propriétés d'adhérence du film au moyen d'un rayonnement électromagnétique;
e) finalisation de la pluralité d'éléments de construction optoélectroniques (1), les corps de substrat de croissance (20) étant retirés intégralement ou seulement partiellement des corps semiconducteurs (2) respectifs et le groupement de supports d'éléments de construction (30) étant séparé en les supports d'éléments de construction.

2. Procédé selon la revendication 1,
dans lequel le support auxiliaire (4) est positionné à l'étape c) par rapport aux supports d'éléments de construction (3) de manière à ce que les corps semiconducteurs (2) soient tournés vers les supports d'éléments de construction (3) et
- à l'étape a) est disposé sur le support auxiliaire (4) au moins un autre corps semiconducteur (2) entre deux corps semiconducteurs (2) qui sont fixés à l'étape d) l'un à côté de l'autre sur des supports d'éléments de construction (3).

3. Procédé selon la revendication 2,
dans lequel le support auxiliaire (4) est doté à l'étape a) de corps semiconducteurs séparés (2), qui sont présélectionnés par rapport à leurs propriétés optoélectroniques.

4. Procédé selon une quelconque des revendications 1 à 3, dans lequel une partie du film reste dans l'élément de construction optoélectronique finalisé sur le corps semiconducteur (20).

5. Procédé selon une quelconque des revendications 1 à 4, dans lequel à l'étape b), au moins une partie de montage (31) respective est constituée sur les supports d'éléments de construction (3), qui est prévue en vue de la fixation d'un corps de semiconducteur (2) et pour lequel des corps semiconducteurs (2A) sont séparés du support auxiliaire (4), qui à l'étape c), sont disposés respectivement au sein d'une partie de montage (31) et des corps semiconducteurs (2B) restent sur le support auxiliaire (4), qui sont disposés en dehors des parties de montage (31).

6. Procédé selon une quelconque des revendications 1 à 5, dans lequel une propriété optoélectronique d'au moins un élément de construction optoélectronique est réglée après la fixation du corps semiconducteur respectif sur le support d'élément de construction.

7. Procédé selon une quelconque des revendications 1 à 6, dans lequel une substance de conversion du rayonnement est constituée sur les corps semiconducteurs, la quantité et/ou la composition de la substance de conversion du rayonnement étant adaptée sélectivement au corps semiconducteur respectif.

8. Procédé selon la revendication 7,
dans lequel, après la fixation du corps semiconducteur sur le groupement de supports d'éléments de construction, une mesure de la luminance et/ou du localisation chromatique est réalisée.

9. Procédé selon une quelconque des revendications 1 à 8, dans lequel les corps semiconducteurs sont détachés du support auxiliaire au moyen d'une exposition sélective du support auxiliaire par rayonnement laser.
